# EUROPEAN PATENT APPLICATION

(11) **EP 4 818 376 A2**
(43) Date of publication of application: **07.10.2026**
(21) Application number: 26193728.8
(22) Date of filing: 27.02.2024
(51) Int. Cl.: C25F 3/12

(54) **METHOD FOR PRODUCING A METAL-BASED COATING ON A FILM OF HARM-STRUCTURES ATTACHED TO A SUPPORT**

(30) Priority: 27.02.2023 FI 20235231; 19.09.2023 TW 112210096 U; 28.09.2023 CN 202322648301 U; 29.09.2023 DE 202023105704 U; 18.10.2023 JP 2023003795 U
(62) Document number(s) of the earlier application(s) in accordance with Art. 76 EPC: 24709663.9 / 4 673 591
(71) Applicant: Canatu Finland Oy, 01720 Vantaa (FI)
(72) Inventor: SOLIMAN, Ahmed, 01720 Vantaa (FI)
(74) Representative: Vossius & Partner Patentanwälte Rechtsanwälte mbB

(57) **Abstract**

The present invention relates to a filter, comprising a support, a film of high aspect ratio molecular structures (HARM-structures) attached to the support, and a transition-metal-based coating on the film of HARM-structures, wherein the film of HARM-structures has a size of 10-200 cm², and a thickness of the formed transition-metal-based coating is 1-500 nm, and wherein an electrical resistance of the formed transition-metal-based coating is higher than an electrical resistance of the film of HARM-structures.

## Description

### FIELD OF THE INVENTION

The present disclosure relates to a filter comprising a film of high aspect ratio molecular structures (HARM-structures). Other aspects of the disclosure relate to a method for producing a metal-based coating on a film of high aspect ratio molecular structures (HARM-structures) attached to a support. The present disclosure further relates to a metal-based coating on a film of HARM-structures attached to a support. The present disclosure further relates to the use of a metal-based coating on a film of HARM-structures attached to a support.

### BACKGROUND OF THE INVENTION

Electrodeposition, or electroplating as it may also be called, is a process of controlled deposition of material on conducting surfaces using electric current from a solution containing ionic species. Electrodeposition is thus a process that uses electric current to reduce dissolved metal cations so that they form a coherent metal-based coating on an electrode. Electrodeposition is widely used to produce a wide variety of two- and three-dimensional materials such as coatings and films. However, there remains a need for method to coat large area films of HARM-structures and for an improved filter based on the film of HARM-structures.

### SUMMARY

A filter is disclosed. The filter comprises a support, a film of high aspect ratio molecular structures (HARM-structures) attached to the support, and a transition-metal-based coating on the film of HARM-structures, wherein the film of HARM-structures has a size of 10-200 cm², and a thickness of the formed transition-metal-based coating is 1-500 nm.

A method for producing a metal-based coating on a film of high aspect ratio molecular structures (HARM-structures) attached to a support is disclosed. The method comprises:
- providing an electrode comprising a film of HARM-structures attached to a support, wherein the support is provided with a current collector;
- subjecting the electrode to an electrodeposition process in an aqueous deposition bath of a metal complex and/or a salt thereof, wherein the electrodeposition process comprises:
   - firstly conducting the electrodeposition at a first potential value being in the range of 0.2 to 5 V to form the metal-based coating on the film of HARM-structures attached to the support; and
   - then conducting the electrodeposition at a second potential value being in the range of 0 to -4 V to etch the formed metal-based coating.

Further is disclosed a metal-based coating on a film of high aspect ratio molecular structures (HARM-structures) attached to a support obtainable by the method as disclosed in the current specification.

Further is disclosed the use of a metal-based coating on a film of high aspect ratio molecular structures (HARM-structures) attached to a support as disclosed in the current specification as a sensor or a filter.

### BRIEF DESCRIPTION OF THE DRAWINGS

The accompanying drawings, which are included to provide a further understanding of the method and the substrate and constitute a part of this specification, illustrate embodiments and together with the description help to explain the principles of the above. In the drawings:
Fig. 1a illustrates an example of a two-electrode system of the electrodeposition process;
Fig. 1b illustrates an example of a three-electrode system of the electrodeposition process;
Fig. 2 illustrates a TEM image of a metal-based coating on a film of HARM-structures according to one embodiment; and
Fig. 3 schematically illustrates an example of a filter.

### DETAILED DESCRIPTION

A filter is disclosed. The filter comprises a support, a film of high aspect ratio molecular structures (HARM-structures) attached to the support, and a transition-metal-based coating on the film of HARM-structures, wherein the film of HARM-structures has a size of 10-200 cm², and a thickness of the formed transition-metal-based coating is 1-500 nm.

A method for producing a metal-based coating on a film of high aspect ratio molecular structures (HARM-structures) attached to a support is disclosed. The method comprises:
- providing an electrode comprising a film of HARM-structures attached to a support, wherein the support is provided with a current collector;
- subjecting the electrode to an electrodeposition process in an aqueous deposition bath of a metal complex and/or a salt thereof, wherein the electrodeposition process comprises:
   - firstly conducting the electrodeposition at a first potential value being in the range of 0.2 to 5 V to form the metal-based coating on the film of HARM-structures attached to the support; and
   - then conducting the electrodeposition at a second potential value being in the range of 0 to -4 V to etch the formed metal-based coating.

Further is disclosed a metal-based coating on a film of high aspect ratio molecular structures (HARM-structures) attached to a support obtainable by the method as disclosed in the current specification.

Further is disclosed the use of a metal-based coating on a film of HARM-structures attached to a support as disclosed in the current specification as a sensor, a filter, or a pellicle, preferably in an extreme ultraviolet (EUV) device. The sensor may be an electrochemical sensor or a biosensor. The filter may be an optical filter, a debris filter, a membrane filter. The pellicle may be an extreme ultraviolet lithography pellicle.

Electrodeposition, or electroplating as it may also be called, is a process of controlled deposition of material on conducting surfaces using electric current from a solution containing ionic species. Electrodeposition is thus a process that uses electric current to reduce/oxidize dissolved ionic species so that they form a coherent metal-based coating on an electrode.

The method comprises providing an electrode comprising a film of HARM-structures attached to a support, wherein the support is provided with a current collector. In electrodeposition, a current collector may be used to collect electrons from the electrodeposition process. The current collector may typically be made of a conductive material, such as metal. The use of the current collector has the added utility of ensuring uniform deposition and controlling the deposition rate during the electroplating process.

In the current disclosure, the provided electrode comprises a film of HARM-structures attached to a support. The electrode may thus be formed of a film of HARM-structures attached to a support. In addition, the support may be provided with a current collector along at least one portion of the support. The current collector may be provided on e.g. at least one edge of the support. The current collector may be of e.g. Ag, Au, Cu, Fe, Pt, C, or any combination or mixture thereof.

The expression a "HARM-structure" or "HARMS" should be understood in this specification, unless otherwise stated, as referring to "nanostructures", i.e. structures with one or more characteristic dimensions in nanometer scale, i.e. less than or equal to about 100 nanometers. "High aspect ratio" refers to dimensions of the conductive structures in two perpendicular directions being in significantly different magnitudes of order. For example, a nanostructure may have a length which is tens or hundreds times higher than its thickness and/or width. In a film of HARM-structures, a great number of said nanostructures are interconnected with each other to form a network of interconnected molecules. As considered at a macroscopic scale, a HARMS network forms a solid, monolithic material in which the individual molecular structures are disoriented or non-oriented, i.e. oriented substantially randomly. Various types of HARM-structure networks can be produced in the form of thin transparent layers with reasonable resistivity. Preferably, the HARM-structures are electrically conductive HARM-structures.

Preferably, the HARM-structures are carbon nanostructures. Preferably, the carbon nanostructures comprise carbon nanotubes (CNT), carbon nanobuds (CNB), carbon nanoribbons, or any combination thereof. Preferably, the carbon nanostructures comprise carbon nanotubes and/or carbon nanobuds. The carbon nanobuds, or the carbon nanobud molecules as they also may be called, have fullerene or fullerene-like molecules covalently bonded to the side of a tubular carbon molecule.

The support may be any type of support suitable to be attached with a film of HARM-structures. The support may be formed of a polymer, a metal, silicon, glass, a ceramic material, or any combination thereof.

The form of the support may vary. The support may have the form of a frame. Preferably, the support has the form of a frame, and the film of HARM-structures is a free-standing film of HARM-structures attached to the frame. The frame may support the free-standing film of HARM-structures at the outer edges thereof such that an unsupported standalone region of the free-standing film of HARM-structures is formed. The support positions may be located anywhere in the structure as long as they provide sufficient support for the free-standing film of HARM-structures. For example, they may be on the sides of the free-standing film of HARM-structures, or in areas near corners, or next to each other along the sides. Any wider area that includes a plurality of support points is also meant to be covered by this aspect, for example if the frame has an uninterrupted circular shape wherein the free-standing region lies within the circle. The frame may also have any other prolonged uninterrupted shape. Preferably, the frame is shaped as a circle, a square, a triangle, a rectangle, an oval, or a polygon.

The support may comprise a network structure, such as a mesh or a grid, which may be composed of interconnected nodes, vertices or edges. The network structure may comprise cells having regular or irregular shapes. The nodes, vertices, edges of the network structure or the cells may be arranged in a regular or a non-regular pattern. The cells may be circular, triangular, rectangular, square, hexagonal, octagonal or otherwise polygonal in shape. The support may also have the form of a network structure disposed in a frame, where the network structure and the frame may be as described above.

The film of HARM-structures may have the size of 0.1 - 10000 cm², or 1 - 7000 cm², or 10 - 5000 cm², or 100 - 3000 cm², or 500 - 2500 cm², or 1000 - 2000 cm². The film of HARM-structures may have the size of 0.1 - 1000 cm², or 1 - 500 cm², or 10 - 200 cm², or 50 - 150 cm². The inventor surprisingly found out that with the disclosed method one is able to form a metal-based coating with electrodeposition process on e.g. a free-standing film of HARM-structures of large size that has not been possible with before.

The inventor surprisingly found out that it is possible to form a metal-based coating on a large area free-standing film of HARM-structures when conducting the electrodeposition process as disclosed in the current specification, i.e. by using the two-step process with different potential values and a predetermined difference there between. During electrodeposition at the first potential value all the HARM-structures of the surface of the film are covered with the metal-complex to deposited thereon. During electrodeposition at the second potential value the formed metal-based coating is etched and possible defects therein are covered with further material to form a uniform metal-based coating.

The term "etch" may be taken to refer to the process taking place during the electrodeposition at the second potential value resulting in removing or shaving away thicker parts of the metal-based coating formed on the film of HARM-structures due to higher availability. Carrying out the electrodeposition at the second potential value may result in a uniform metal-based coating being formed.

The first potential value may be in the range of 0.2 to 5 V, or 0.3 to 3 V, or 0.5 to 2 V, or 1 to 1.5 V. The second potential value may be in the range of 0 to -4 V, or -0.1 to -3 V, or -0.3 to -2 V, or -0.5 to -1 V. The difference between the first potential value and the second potential value may be 0.2 - 9 V, or 0.4 - 6 V, or 0.8 - 4 V, or 1.5 - 2 V.

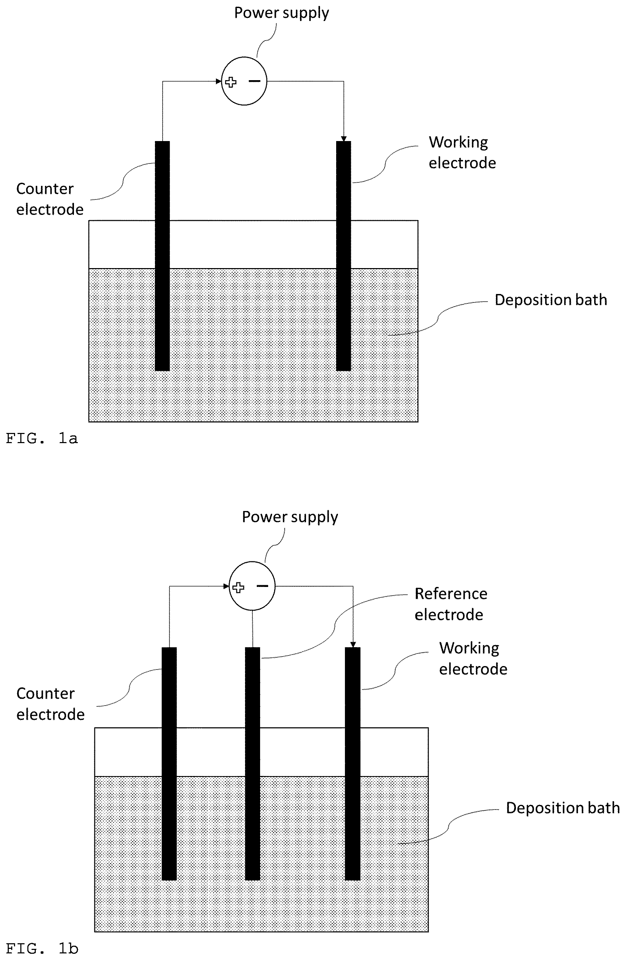

The electrodeposition process may be conducted as a two-electrode system or a three-electrode system. The two-electrode system may be taken to consist of two electrodes, i.e. a working electrode and a counter electrode that also functions as the reference electrode. An example of a two-electrode system is disclosed in Fig. 1a. The three-electrode system may be taken to consist of three electrodes, i.e. a working electrode, counter electrode, and reference electrode. The reference electrode's role is to act as a reference in measuring and controlling the working electrode potential, without passing any current. An example of a three-electrode system is disclosed in Fig. 1b.

A polymer primer may be provided between the film of HARM-structures and the support in order to enhance adhesion of the film of HARM-structures to the support and/or to improve electrical conductivity. The polymer primer may be formed by using a dispersion of a halogenated and/or sulfonated polymer selected from polyvinylidene chloride (PVDC), polyvinylidene fluoride (PVDF), sulfonated tetrafluoroethylene based fluoropolymer-copolymer (Nafion), polystyrene sulfonate (PSS), or any combination thereof. The polymer primer may thus comprise or consist of a halogenated and/or sulfonated polymer selected from polyvinylidene chloride (PVDC), polyvinylidene fluoride (PVDF), sulfonated tetrafluoroethylene based fluoropolymer-copolymer (Nafion), polystyrene sulfonate (PSS), or any combination thereof.

The electrodeposition process may be carried out for 1 - 5000 seconds, or 5 - 500 seconds, or 10 - 300 seconds, or 20 - 100 seconds.

Conducting the electrodeposition at the first potential value may be carried out for 1 - 30 seconds, or 30 - 300 seconds, or 300 - 5000 seconds. Conducting the electrodeposition at the first potential value may be carried out for 1 - 1000 seconds, or 10 - 600 seconds, or 20 - 200 seconds, or 30 - 150 seconds.

Conducting the electrodeposition at the second potential value may be carried out for 1 - 30 seconds, or 30 - 300 seconds, or 300 - 5000 seconds. Conducting the electrodeposition at the second potential value may be carried out for 1 - 1000 seconds, or 50 - 600 seconds, or 100 - 400 seconds, or 150 - 350 seconds.

The electrodeposition process may be continued until the thickness of the formed metal-based coating is 1 - 500 nm, or 1 - 300 nm, or 1 - 100 nm, or 1 - 50 nm, or 1 - 30 nm, or 1 - 20 nm, or 1 - 10 nm. The thickness may be measured with e.g. transmission electron microscopy (TEM) technique, scanning electron microscopy (SEM) technique, or any other relevant technique.

The electrode is subjected to the electrodeposition process in an aqueous deposition bath of a metal complex and/or a salt thereof. No supporting electrolyte is needed to be used in the aqueous deposition bath. A film of HARM-structures, such as carbon nanotubes, are known to be highly hydrophobic, whereby non-aqueous deposition baths have previously been used. The inventor surprisingly found out that an aqueous deposition bath could be used in the electrodeposition process. Using an aqueous deposition bath has the added utility of being an environmentally friendly and safe to use deposition bath. In addition, the use of an aqueous deposition bath has the added utility of providing a high deposition rate providing thereby a fast process. The aqueous deposition bath further provides a high HARMS to electrolyte conductivity ratio and reduces the need of using supporting electrolyte. The addition of a supporting electrolyte in the deposition bath may increase the risk of particle contamination on the HARMS due to surface crystallization.

The method may comprise subjecting the aqueous deposition bath to degassing carried out by vacuum cycles and/or by purging inert gas through the aqueous deposition bath.

The metal complex to be used in the aqueous deposition bath may be selected such that the resistance of the formed metal-based coating is higher than the resistance of the film of HARM-structures. One is able to measure the resistance of the film of HARM-structures before the coating by using a four-point probe, a two-point probe, eddy current, or terahertz.

The resistance of the combination of the formed metal-based coating on the film of HARM-structures may be 10 Ω - 1 kΩ, or 1 - 100 kΩ, or 100 - 1000 kΩ. The resistance of the film of HARM-structures is 10 Ω - 10 kΩ, or 10 Ω - 1 kΩ, or 20 - 500 Ω, or 30 - 350 Ω, or 40 - 250 Ω, or 50 - 200 Ω, or 60 - 150 Ω. A four-point probe, a two-point probe, eddy current, or terahertz, may be used for measuring the resistance of the combination of the metal-based coating on the film of HARM-structures.

The metal complex may be selected such that the resistance of the formed metal-based coating is higher than the resistance of the film of HARM-structures. Thus, the higher resistance of the metal-based coating than of the film of HARM-structures can be observed by the increase in the resistance of the formed structure after deposition of metal-based coating on the film of HARM-structures.

The expression a "metal complex" should be understood in this specification, unless otherwise stated, as referring to a compound comprising or consisting of a metal ion bonded to one or more ligands. The metal ion acts as the central atom and the ligands are usually neutral molecules or anions that are bonded to the metal through coordinate covalent bonds. The properties of metal complexes are determined by the type of metal ion and the nature of the ligands, as well as their oxidation state and coordination number.

The metal complex may be a transition metal complex. The metal complex may be a sulphur-based metal complex, an oxygen-based metal complex, or an oxysulphur-based metal complex. The metal complex may be a sulphur-based transition metal complex, an oxygen-based transition metal complex, or an oxysulphur-based transition metal complex. The transition metal may be selected from a group consisting of Mo, W, Cu, Zr, Ti, Nb, V, Hf, Cr, Zn, Fe, Ni, and Co. Preferably, the transition metal is Mo or W.

In addition to (transition) metal, the metal complex may comprise sulphur, oxygen, hydrogen, carbon, nitrogen, or any combination or mixture thereof.

The metal complex may be denoted as [M_{α}C_{β}H_{γ}N_{δ}O_{ε}S_{ζ}], wherein
M is a transition metal ion,
α is a value of 1 - 20, and
β, γ, δ, ε, ζ, are each independently a value of 0 - 50.

Preferably, the metal complex is denoted as [M_{α}S_{ζ}], [M_{α}O_{ε}] [M_{α}O_{ε}S_{ζ}], [M_{α}O_{ε}H_{γ}S_{ζ}], [M_{α}C_{β}H_{γ}O_{ζ}], or [M_{α}C_{β}H_{γ}O_{ε}S_{ζ}], [M_{α}C_{β}H_{γ}N_{δ}O_{ε}S_{ζ}], wherein
M is a transition metal ion,
α is a value of 1 - 20, and
β, γ, δ, ε, ζ, are each independently a value of 1 - 50.

The transition metal ion may be an ion of Mo, W, Cu, Zr, Ti, Nb, V, Hf, Cr, Zn, Fe, Ni, or Co.

The metal complex may be in the form of a salt. Examples of such a salt may be ammonium salt or sodium salt of the metal complex.

The aqueous deposition bath may thus be a deposition bath formed of water and a metal complex and/or a salt thereof. The aqueous deposition bath may further comprise additives such as organic brighteners, throwing power enhancers, and adhesion promoters. Preferably, the aqueous deposition bath consists of water and a metal complex and/or a salt thereof. The concentration of the metal complex in the aqueous deposition bath may be 0.001 mM - 3 M, or 0.1 mM - 1 M, or 0.2 - 500 mM, or 0.3 - 100 mM, or 0.4 - 50 mM, or 0.5 - 10 mM, or 0.6 - 5 mM, or 0.7 - 3 mM. Using a low concentration of the metal complex in the deposition bath has the added utility of enabling one to control the uniformity of the produced film as it is easier to control the material balance and the mass diffusion.

The formed metal-based coating may be a coating of a transition metal, such as a transition metal dichalcogenide. The transition metal may be Mo, W, Cu, Zr, Ti, Nb, V, Hf, Cr, Zn, Fe, Ni, or Co.

The method as disclosed in the current specification has the added utility of allowing ultra-fast production of uniform and large area depositions over free-standing or supported films of HARM-structures. The method as disclosed in the current specification may find use in various applications such as filters, preferably filters in an EUV device, EUV pellicles, electrochromic displays and electrochemical sensors.

### EXAMPLES

Reference will now be made in detail to the described embodiments, examples of which are illustrated in the accompanying drawings.

The description below discloses some embodiments in such a detail that a person skilled in the art is able to utilize the method based on the disclosure. Not all steps of the embodiments are discussed in detail, as many of the steps will be obvious for the person skilled in the art based on this specification.

Fig. 1a illustrates an example of a two-electrode system which may be used for producing a metal-based coating on a film of HARM-structures attached to a support according to one embodiment. The two-electrode system of Fig. 1a consists of two electrodes, i.e. a working electrode and a counter electrode that also functions as the reference electrode.

Fig. 1b illustrates an example of a three-electrode system which may be used for producing a metal-based coating on a film of HARM-structures attached to a support according to one embodiment. The three-electrode system of Fig. 1b consists of three electrodes, i.e. a working electrode, counter electrode, and reference electrode. The reference electrode's role is to act as a reference in measuring and controlling the working electrode potential, without passing any current.

### EXAMPLE 1 - Forming a metal-based coating on a film of HARM-structures attached to a support

In this example metal-based coatings were formed on films of HARM-structures attached to a support. Firstly was provided an electrode by attaching a preprepared film of HARM-structures to a support with a current collector, which in these samples was an Ag conduct. The formed electrodes were then subjected to the electrodeposition process in an aqueous deposition bath that was formed by using a salt of a metal complex, and then the electrodeposition process was carried out as described in the current specification.

The following materials and parameters were used in the examples:

| | Sample 1 | Sample 2 | Sample 3 | Sample 4 |
|---|---|---|---|---|
| HARM-structures | CNT | CNT | CNT | CNT |
| Material of the support | PMMA | Quartz | Si | Steel |
| Form of the support | Frame | Frame | Frame | Frame |
| Area of the film of HARM-structures | 49 cm² | 162 cm² | 49 cm² | 160.5 cm² |
| Polymer primer | PVDC | NA | PVDC | NA |
| Metal complex in the deposition bath | (NH₄)₂[MoS₄] | (NH₄)₂[WS₄] | Na₂[MoO₄] | N(C₂H₅) ₄[MoS₄] |
| Concentration of metal complex in the deposition bath | 2 mM | 1 mM | 2 mM | 0.5 mM |
| First potential value | 1.0 V | 1.0 V | 0.9 V | 0.8 V |
| Second potential value | -1.0 V | -1.2 V | -1.0 V | -1.0 V |
| Difference between first and second potential value | 2.0 V | 2.2 V | 1.9 V | 1.8 V |
| Time for conducting the deposition | 360 s | 460 s | 250 s | 260 s |
| Time for conducting electrodeposition at the first potential value | 60 s | 120 s | 60 s | 30 s |
| Time for conducting electrodeposition at the second potential value | 300 s | 340 s | 190 s | 230 s |
| Resistance of the film of HARM-structures | 150 ohms | 15 ohms | 150 ohms | 350 ohms |
| Resistance of the combination of the metal-based coating on the film of HARM-structures | 1000 ohms | 2000 ohms | 3500 ohms | 500 ohms |
| Thickness of the metal-based coating | ~10 nm | ~20 nm | ~10-50 nm | ~1-5 nm |

| | | | | |
|---|---|---|---|---|
| CNT = carbon nanotube PMMA = Polymethylmethacrylate PVDC = polyvinylidene chloride NA = not applied | | | | |

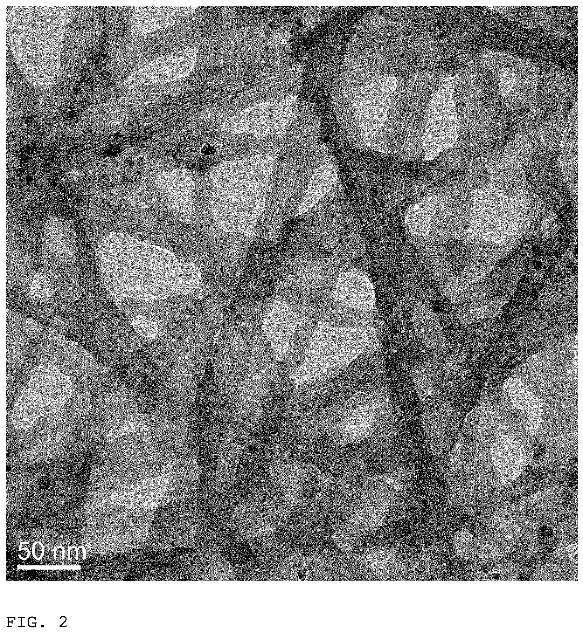

From the above results one may see that one may produce a metal-based coating on a free-standing film of HARM-structures by the applied method. One may further provide a metal-based coating having a resistance that is higher than the resistance of the free-standing film of HARM-structures. Further, from Fig. 2, it was determined that a highly uniform metal-based coating on the free-standing film of HARM-structures can be formed by the two-step electrodeposition process.

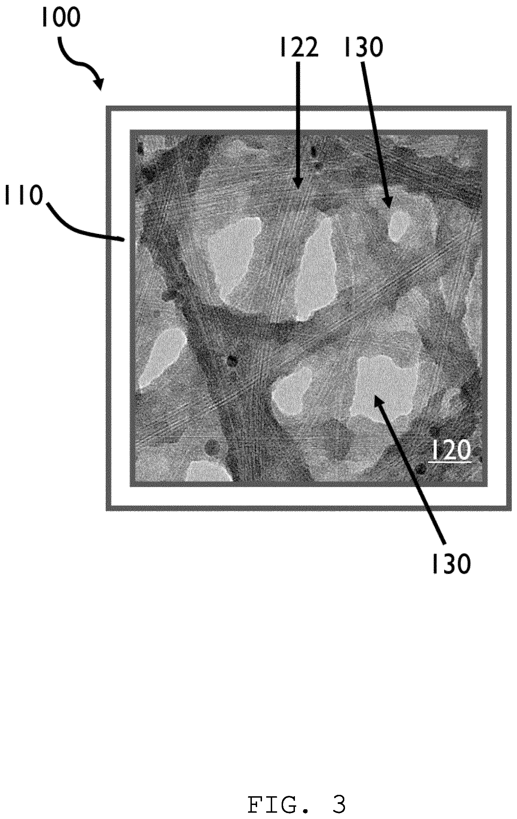

As an example of the filter of the present invention, Fig. 3 schematically illustrates a filter 100. This illustration is provided for a better understanding of the structure of the filter and, in order to show the support and the HARM-structures in a same figure, is apparently not made to scale. The filter 100 comprises a support 110, a film of HARM-structures 120 attached to the support 110, and a transition-metal-based coating 130 on the film of HARM-structures 120.

In this example, the film of HARM-structures 120 comprises individual HARM-structure 122 (i.e., CNT in this example). The present application uses the expression "a transition-metal-based coating on the film of HARM-structures" since the product may be manufactured by first obtaining the film of HARM-structures 120 and then forming the transition-metal-based coating 130 on the film 120, as described in "EXAMPLE 1" above. The expression notably does not exclude configurations in which individual HARM-structure 122 is covered with the coating 130, as also seen in Fig. 3. Not necessarily all the HARM-structures 122 are covered completely by the metal-based coating 130. The coverage may be dependent on how densely the HARM-structures 122 are arranged. For example, some of the HARM-structures 122 may be covered while some are not, or in some places the same individual HARM-structure 122 may be covered all around (a 360° coverage) and in some places it may not be in contact with the metal-based coating 130 at all. All these variations are intended to be covered by the expression "a transition-metal-based coating on the film of HARM-structures".

It is obvious to a person skilled in the art that with the advancement of technology, the basic idea may be implemented in various ways. The embodiments are thus not limited to the examples described above; instead they may vary within the scope of the claims.

The embodiments described hereinbefore may be used in any combination with each other. Several of the embodiments may be combined together to form a further embodiment. A filter, a method, a metal-based coating on a film of HARM-structures attached to a support, or a use as disclosed herein, may comprise at least one of the embodiments described hereinbefore. It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items. The term "comprising" is used in this specification to mean including the feature(s) or act(s) followed thereafter, without excluding the presence of one or more additional features or acts.
The following aspects are preferred embodiments of the present invention:
1. A method for producing a metal-based coating on a film of high aspect ratio molecular structures (HARM-structures) attached to a support, wherein the method comprises:
   - providing an electrode comprising a film of HARM-structures attached to a support, wherein the support is provided with a current collector;
   - subjecting the electrode to an electrodeposition process in an aqueous deposition bath of a metal complex and/or a salt thereof, wherein the electrodeposition process comprises:
      - firstly conducting the electrodeposition at a first potential value being in the range of 0.2 to 5 V to form the metal-based coating on the film of HARM-structures attached to the support; and
      - then conducting the electrodeposition at a second potential value being in the range of 0 to -4 V to etch the formed metal-based coating.
2. The method of aspect 1, wherein the support has the form of a frame, and the film of HARM-structures is a free-standing film of HARM-structures attached to the frame.
3. The method of any one of the preceding aspects, wherein the film of HARM-structures has the size of size of 0.1 - 1000 cm², or 1 - 500 cm², or 10 - 200 cm², or 50 - 150 cm².
4. The method of any one of the preceding aspects, wherein the first potential value is in the range of 0.3 to 3 V, or 0.5 to 2 V, or 1 to 1.5 V.
5. The method of any one of the preceding aspects, wherein the second potential value is in the range of 0 to -4 V, or -0.1 to -3 V, or -0.3 to -2 V, or -0.5 to -1 V.
6. The method of any one of the preceding aspects, wherein the difference between the first potential value and the second potential value is 0.2 - 9 V, or 0.4 - 6 V, or 0.8 - 4 V, or 1.5 - 2 V.
7. The method of any one of the preceding aspects, wherein a polymer primer is provided between the film of HARM-structures and the support in order to enhance adhesion of the film of HARM-structures to the support and/or to improve electrical conductivity.
8. The method of any one of the preceding aspects, wherein the support is formed of a polymer, a metal, silicon, glass, a ceramic material, or any combination thereof.
9. The method of any one of the preceding aspects, wherein the electrodeposition at the first potential value is carried out for 1 - 1000 seconds, or 10 - 600 seconds, or 20 - 200 seconds, or 30 - 150 seconds.
10. The method of any one of the preceding aspects, wherein the electrodeposition at the second potential value is carried out for 1 - 1000 seconds, or 50 - 600 seconds, or 100 - 400 seconds, or 150 - 350 seconds.
11. The method of any one of the preceding aspects, wherein the metal complex is selected such that the resistance of the formed metal-based coating is higher than the resistance of the film of HARM-structures alone.
12. The method of any one of the preceding aspects, wherein the metal complex is a sulphur-based metal complex, an oxygen-based metal complex, or an oxy-sulphur-based metal complex.
13. The method of any one of the preceding aspects, wherein, in addition to metal, the metal complex comprises sulphur, oxygen, hydrogen, carbon, nitrogen, or any combination or mixture thereof.
14. The method of any one of the preceding aspects, wherein no supporting electrolyte is used in the aqueous deposition bath.
15. The method of any one of the preceding aspects, wherein the method comprises subjecting the aqueous deposition bath to degassing carried out by vacuum cycles and/or by purging inert gas through the aqueous deposition bath.
16. The method of any one of the preceding aspects, wherein the electrodeposition process is continued until the thickness of the formed metal-based coating is 1 - 500 nm, or 1 - 300 nm, or 1 - 100 nm, or 1 - 50 nm, or 1 - 30 nm, or 1 - 20 nm, or 1 - 10 nm, or 10 - 500 nm, or 10 - 300 nm, or 10 - 100 nm, or 10 - 50 nm, or 10 - 30 nm, or 10 - 20 nm.
17. The method of any one of the preceding aspects, wherein the resistance of the combination of formed metal-based coating on the film of HARM-structures is 10 Ω - 1 kΩ, or 1 - 100 kΩ, or 100 - 1000 kΩ.
18. The method of any one of the preceding aspects, wherein the resistance of the film of HARM-structures is 10 Ω - 10 kΩ, or 10 Ω - 1 kΩ, or 20 - 500 Ω, or 30 - 350 Ω, or 40 - 250 Ω, or 50 - 200 Ω, or 60 - 150 Ω.
19. The method of any one of the preceding aspects, wherein the electrodeposition process is conducted as a two-electrode system or a three-electrode system.
20. A metal-based coating on a film of high aspect ratio molecular structures (HARM-structures) attached to a support obtainable by the method of any one of aspects 1 - 19.
21. Use of a metal-based coating on a film of high aspect ratio molecular structures (HARM-structures) attached to a support of aspect 20 as a sensor, a filter, or a pellicle, preferably in an extreme ultraviolet (EUV) device.
22. The use of aspect 21, wherein the sensor is an electrochemical sensor or a biosensor.
23. The use of aspect 21 or 22, wherein the filter is an optical filter, a debris filter, or a membrane filter, preferably in an EUV device.
24. The use of aspect 21, 22 or 23, wherein the pellicle is an EUV lithography pellicle.
25. A filter, comprising:
   a support,
   a film of high aspect ratio molecular structures (HARM-structures) attached to the support, and
   a transition-metal-based coating on the film of HARM-structures,
   wherein the film of HARM-structures has a size of 10-200 cm², and a thickness of the formed transition-metal-based coating is 1-500 nm.
26. The filter of aspect 25, which is a debris filter, an optical filter, or a combination thereof.
27. The filter of aspect 25 or 26, which is a debris filter, an optical filter, or a combination thereof in an EUV device.
28. The filter of any one of aspects 25-27, wherein the support has the form of a frame, and the film of HARM-structures is a free-standing film of HARM-structures attached to the frame.
29. The filter of aspect 28, wherein the frame supports the free-standing film of HARM-structures at outer edges thereof such that an unsupported standalone region of the free-standing film of HARM-structures is formed.
30. The filter of any one of aspects 25-29, wherein the frame is shaped as a circle, a square, a triangle, a rectangle, an oval or a polygon.
31. The filter of any one of aspects 25-30, wherein the support is formed of a polymer, a metal, silicon, glass, a ceramic material or any combination thereof.
32. The filter of any one of aspects 25-31, wherein the HARM-structures are nanostructures with one or more characteristic dimensions in less than or equal to 100 nanometers, the nanostructure each having a length which is tens or hundreds times higher than its thickness and/or width.
33. The filter of any one of aspects 25-32, wherein the HARM-structures are carbon nanostructures.
34. The filter of aspect 33, wherein the carbon nanostructures comprise carbon nanotubes (CNT), carbon nanobuds (CNB), carbon nanoribbons, or any combination thereof.
35. The filter of any one of aspects 25-34, wherein a polymer primer is provided between the film of HARM-structures and the support.
36. The filter of any one of aspects 25-35, wherein the thickness of the formed transition-metal-based coating is 10-500 nm, 10-300 nm, or 10-100 nm, or 10-50 nm, or 10-30 nm, or 10-20 nm.
37. The filter of any one of aspects 25-36, wherein a resistance of the formed transition-metal-based coating is higher than a resistance of the film of HARM-structures.
38. The filter of any one of aspects 25-37, wherein the transition metal comprises Mo, W, Cu, Zr, Ti, Nb, V, Hf, Cr, Zn, Fe, Ni, or Co.
39. The filter of any one of aspects 25-38, wherein the formed transition-metal-based coating comprises a transition metal dichalcogenide.
40. The filter of any one of aspects 25-39, wherein the support is provided with a current collector.
41. The filter of any one of aspects 25-40, wherein the support is provided with a current collector along at least one portion of the support.
42. The filter of any one of aspects 25-41, wherein the current collector provided on at least one edge of the support.
43. The filter of any one of aspects 25-42, wherein the support comprises a network structure, such as a mesh or a grid, which is optionally disposed in a frame, wherein cells of the mesh or the grid may be circular, triangular, rectangular, square, hexagonal, octagonal, or otherwise polygonal in shape.

## Claims

1. A filter, comprising:
a support,
a film of high aspect ratio molecular structures (HARM-structures) attached to the support, and
a transition-metal-based coating on the film of HARM-structures,
wherein the film of HARM-structures has a size of 10-200 cm², and a thickness of the formed transition-metal-based coating is 1-500 nm, and
wherein an electrical resistance of the formed transition-metal-based coating is higher than an electrical resistance of the film of HARM-structures.

2. The filter of claim 1, which is a debris filter, an optical filter, or a combination thereof
wherein, the filter is preferably a debris filter, an optical filter, or a combination thereof in an EUV device.

3. The filter of any one of claims 1-2, wherein the support has the form of a frame, and the film of HARM-structures is a free-standing film of HARM-structures attached to the frame,
preferably, wherein the frame supports the free-standing film of HARM-structures at outer edges thereof such that an unsupported standalone region of the free-standing film of HARM-structures is formed.

4. The filter of any one of claims 1-3, wherein the frame is shaped as a circle, a square, a triangle, a rectangle, an oval or a polygon.

5. The filter of any one of claims 1-4, wherein the support is formed of a polymer, a metal, silicon, glass, a ceramic material or any combination thereof.

6. The filter of any one of claims 1-5, wherein the HARM-structures are nanostructures with one or more characteristic dimensions in less than or equal to 100 nanometers, the nanostructure each having a length which is tens or hundreds times higher than its thickness and/or width.

7. The filter of any one of claims 1-6, wherein the HARM-structures are carbon nanostructures,
preferably, the carbon nanostructures comprise carbon nanotubes, CNT), carbon nanobuds, CNB), carbon nanoribbons, or any combination thereof.

8. The filter of any one of claims 1-7, wherein a polymer primer is provided between the film of HARM-structures and the support.

9. The filter of any one of claims 1-8, wherein the thickness of the formed transition-metal-based coating is 10-500 nm, 10-300 nm, or 10-100 nm, or 10-50 nm, or 10-30 nm, or 10-20 nm.

10. The filter of any one of claims 1-9, wherein the transition metal comprises Mo, W, Cu, Zr, Ti, Nb, V, Hf, Cr, Zn, Fe, Ni, or Co.

11. The filter of any one of claims 1-10, wherein the formed transition-metal-based coating comprises a transition metal dichalcogenide.

12. The filter of any one of claims 1-11, wherein the support is provided with a current collector,
preferably, wherein the support is provided with a current collector along at least one portion of the support,
more preferably, wherein the current collector is provided on at least one edge of the support.

13. The filter of any one of claims 1-12, wherein the support comprises a network structure, such as a mesh or a grid, which is optionally disposed in a frame, wherein cells of the mesh or the grid may be circular, triangular, rectangular, square, hexagonal, octagonal, or otherwise polygonal in shape.

14. An extreme ultraviolet lithography, EUV, pellicle, comprising:
a support,
a film of high aspect ratio molecular structures (HARM-structures) attached to the support, and
a transition-metal-based coating on the film of HARM-structures,
wherein the film of HARM-structures has a size of 10-200 cm², and a thickness of the formed transition-metal-based coating is 1-500 nm, and
wherein an electrical resistance of the formed transition-metal-based coating is higher than an electrical resistance of the film of HARM-structures.

15. The EUV pellicle of claim 14, wherein the transition-metal-based coating comprises one or more transition metals selected from a group consisting of Mo, W, Cu, Zr, Ti, Nb, V, Hf, Cr, Zn, Fe, Ni, and Co.
